(19)

Europäisches
Patentamt
European
Patent Office
Office européen
des brevets

(11)  EP 2 843 844 B1

(12)  **EUROPEAN PATENT SPECIFICATION**

(45) Date of publication and mention
of the grant of the patent:
**07.11.2018  Bulletin 2018/45**

(51) Int Cl.:
***H03M 13/11*** *(2006.01)*

(21) Application number: **13306203.4**

(22) Date of filing: **03.09.2013**

(54) **Transmitter and receiver**

Sender und Empfänger

Émetteur et récepteur

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**04.03.2015  Bulletin 2015/10**

(73) Proprietor: **Alcatel Lucent**
**91620 Nozay (FR)**

(72) Inventor: **Schmalen, Laurent**
**70435 Stuttgart (DE)**

(74) Representative: **Nokia EPO representatives**
**Nokia Technologies Oy**
**Karaportti 3**
**02610 Espoo (FI)**

(56) References cited:

- **NAKAMURA M ET AL: "Ternary phase shift keying and its performance", WIRELESS PERSONAL MULTIMEDIA COMMUNICATIONS, 2002. THE 5TH INTERNATION AL SYMPOSIUM ON OCT. 27-30, 2002, IEEE, PISCATAWAY, NJ, USA, vol. 3, 27 October 2002 (2002-10-27), pages 1284-1288, XP010619300, ISBN: 978-0-7803-7442-3**
- **ZAHRA FARAJI-DANA ET AL: "On Non-Binary Constellations for Channel-Coded Physical-Layer Network Coding", IEEE TRANSACTIONS ON WIRELESS COMMUNICATIONS, IEEE SERVICE CENTER, PISCATAWAY, NJ, US, vol. 12, no. 1, 1 January 2013 (2013-01-01), pages 312-319, XP011489071, ISSN: 1536-1276, DOI: 10.1109/TWC.2012.120312.120469**
- **FLANAGAN M F ET AL: "Linear-Programming Decoding of Nonbinary Linear Codes", IEEE TRANSACTIONS ON INFORMATION THEORY, IEEE PRESS, USA, vol. 55, no. 9, 1 September 2009 (2009-09-01), pages 4134-4154, XP011272471, ISSN: 0018-9448, DOI: 10.1109/TIT.2009.2025571**
- **XIANGMING LI ET AL: "Good LDPC codes over GF(q) for bandwidth efficient transmission", SIGNAL PROCESSING ADVANCES IN WIRELESS COMMUNICATIONS, 2003. SPAWC 200 3. 4TH IEEE WORKSHOP ON ROME, ITALY 15-18 JUNE 2003, PISCATAWAY, NJ, USA,IEEE, US, 15 June 2003 (2003-06-15), pages 95-99, XP010713470, DOI: 10.1109/SPAWC.2003.1318929 ISBN: 978-0-7803-7858-2**
- **WYMEERSCH H ET AL: "Computational complexity and quantization effects of decoding algorithms for non-binary ldpc codes", ACOUSTICS, SPEECH, AND SIGNAL PROCESSING, 2004. PROCEEDINGS. (ICASSP ' 04). IEEE INTERNATIONAL CONFERENCE ON MONTREAL, QUEBEC, CANADA 17-21 MAY 2004, PISCATAWAY, NJ, USA,IEEE, PISCATAWAY, NJ, USA, vol. 4, 17 May 2004 (2004-05-17), pages 669-672, XP010718557, DOI: 10.1109/ICASSP.2004.1326915 ISBN: 978-0-7803-8484-2**
- **KOIKE T ET AL: "Space-time trellis-coded ternary PSK for mobile communications", ELECTRONICS LETTERS, IEE STEVENAGE, GB, vol. 40, no. 16, 5 August 2004 (2004-08-05), pages 1011-1012, XP006022440, ISSN: 0013-5194, DOI: 10.1049/EL:20045216**

EP 2 843 844 B1

**Description**

Embodiments relate to communication systems and, more particularly but not limited thereto, to optical communication systems.

Background

This section introduces aspects that may be helpful in facilitating a better understanding of embodiments. Accordingly, the statements of this section are to be read in this light and are not to be understood as admissions about what is in the prior art or what is not in the prior art.

Today, coherent transmission systems may be applied both in terrestrial and submarine optical fiber networks, for example. Long reach submarine networks may be operated at an extremely low Optical Signal-To-Noise Ratio (OSNR). For these reasons, often the noise-robust Binary Phase Shift Keying (BPSK) modulation format is employed both in research and in commercial field systems. BPSK uses two phases which are separated by 180° and can thus also be termed 2-PSK. In addition BPSK offers significant advantages with respect to hardware implementation complexity. Beside the practical aspects, BPSK is far from being perfect from an information theory point of view.

Nakamura et al: "Ternary phase shift keying and its Performance", Wireless Personal Multimedia Communications, 2002, IEEE, vol. 3, 27.10.2002, pages 1284-1288, describes a combination of Ternary phase shift keying (TPSK) and error correcting codes to transform information binary signals to ternary signals.

Zahra Faraji-Dana et al: "On Non-Binary Constellations for Channel-Coded Physical-Layer Network Coding", IEEE Transactions on Wireless Communications, IEEE, vol. 12, no. 1, 1.1.2013, pages 312-319, consider two-way wireless relaying, for which network coding is employed at the physical layer. Non-binary constellations are used and network-coded combinations are directly decoded over finite fields from the superimposed channel-coded packets, using either a practical RS-CC concatenation or LDPC code. When using LDPC codes, for quasi-static Rayleigh fading and Rayleigh fast fading Channels, the finite fields GF(3) and GF($2^2$) outperform the binary case by attempting to decode multiple network-coded combinations.

Flanagan et al: "Linear-Programming Decoding of Non-binary Linear Codes", IEEE Transactions on Information Theory, IEEE Press, vol. 55, no. 9, 1.9.2009, pages 4134-4154, develop a framework for linear-programming (LP) decoding of non-binary linear codes over rings. LP decoding is simulated for medium-length ternary and quaternary low-density parity-check (LDPC) codes with corresponding PSK modulations over AWGN.

Wymeersch et al: "Computational complexity and quantization effects of decoding algorithms for non-binary LDPC codes", Acoustics, Speech, and Signal Processing, 2004, IEEE, vol. 4, 17.5.2004, pages 669-672, deal with the comparison of the sum-product algorithm (SPA) and its log-domain Version (log-SPA) for decoding LDPC codes over general binary extension fields, GF (q).

Summary

The invention is defined in the independent claims. Advantageous embodiments are defined in the dependent claims.

Some simplifications may be made in the following summary, which is intended to highlight and introduce some aspects of the various exemplary embodiments, but such simplifications are not intended to limit the scope of embodiments. Detailed descriptions of one or more preferred exemplary embodiments adequate to allow those of ordinary skill in the art to make and use the inventive concepts will follow in later sections.

Embodiments propose abandoning the mentioned BPSK transmission in favor of a modulation scheme that allows modulating more bits/symbol and, optionally, still keeps Forward Error Correction (FEC) encoder and/or decoder complexity low. Further, embodiments allow for higher coding gains, as the gap of its modulation constrained capacity to the Shannon limit according to the Shannon-Hartley theorem is smaller. In information theory, the Shannon-Hartley theorem tells the maximum rate at which information can be transmitted over a communications channel of a specified bandwidth in the presence of noise.

In particular, embodiments propose using a ternary modulation format which allows a capacity gain together with a high robustness against phase noise. Further, FEC encoder and/or decoder complexity may still be kept low in comparison with conventional higher order *M*-ary modulation formats, where *M* is an integer power of 2.

According to a first aspect, embodiments provide a transmitter. The transmitter includes a binary-to-ternary converter which is configured or operable to convert a binary signal to a ternary signal. Further, the transmitter includes a modulator which is configured or operable to select, corresponding to the ternary signal, one or more complex valued modulation symbols from a ternary constellation diagram and to transmit the modulation symbols over a communication/transmission channel.

According to some embodiments the proposed transmitter may serve for performing a corresponding transmission method. Said transmission method comprises an act of converting a binary signal to a ternary signal, and an act of selecting, corresponding to the ternary signal, a complex-valued modulation symbol from a ternary constellation diagram. The transmitter may for example be comprised by an optical communications device, such as an optical transmitter, which may comprise further transmitter circuitry, such as mixers, Digital-to-Analog Converters (DACs), modulators, outer encoders, analog and/or digital signal processors, etc. The ternary modulation symbols may be transmitted over an optical communication channel, such as an optical fiber, for example. However, it will be appreciated by the skilled person that embodiments may also be beneficial for other than optical communication systems, such as wireless communication systems, for example.

In one or more embodiments the ternary signal may be defined over the finite field or Galois field GF(3). Thereby a Galois field is a finite algebraic structure (field) that contains a finite number of elements, i.e., three elements in embodiments. Hence, ternary digits of the ternary signal, which may also be referred to as tets/trits (abbreviation for ternary/trinary digits), may be chosen from a ternary/trinary alphabet. For example, the trinary alphabet may comprise the three digits 0, 1, and 2. Hence, the binary to ternary converter may be operable to convert a binary signal from the base 2 numeral system to the base-3 numeral system. Analogous to a bit, a ternary digit is a trit (trinary digit) or tet. Thereby one tet contains $\log_2(3)$ (about 1.58496) bits of information.

For the case that not all ternary symbols have the same probability of occurrence, the output of the binary to ternary converter may be coupled to an optional (ternary) scrambler for ensuring a uniform distribution of the tets and/or modulation symbols. Thereby the scrambler may be based on a Pseudo-Random Ternary Sequence (PRTS), for example, which may be added to the binary to ternary converted symbols. Hence, some embodiments comprise an additive or multiplicative ternary scrambler coupled to the output of the binary to ternary converter. The scrambler is configured or operable to scramble the binary to ternary converted symbols, e.g. based on a PRTS, which may be generated by means of a Linear Feedback Shift Register (LFSR) of the scrambler. It will be apparent to the skilled person that a corresponding receiver will make use of an according descrambler in some embodiments.

In some embodiments the modulator may be operable or configured to select a complex valued modulation symbol corresponding to a tet according to a ternary Phase-Shift Keying modulation scheme, which may also be referred to as 3-PSK modulation scheme. Here, the complex valued modulation symbols may be distributed on the unit circle 120° apart from each other. That is to say, the modulator may be operable to select a complex valued modulation symbol y (in the baseband domain) from a modulation symbol set $\{\exp(i(2\pi/3+O)), \exp(i(4\pi3+O)), \exp(i(2\pi+O))\}$, with $O$ being an arbitrary fixed phase offset factor and i being the imaginary unit with $i^2 = -1$.

In some embodiments the transmitter may further comprise an encoder which is operable or configured to encode the binary signal or preferably the ternary signal according to a Forward Error Encoding (FEC) scheme prior, i.e., upstream, to the modulator. In particular, some embodiments may use the binary-to-ternary conversion together with a non-binary spatially coupled FEC coding scheme over the field GF(3) adapted to the ternary modulation format. In one or more embodiments the encoder may be a (non-binary) Low-Density Parity-Check (LDPC) block or convolutional encoder. Thereby, a Low-Density Parity-Check (LDPC) block code is a linear error correcting code for transmitting a message over a noisy transmission channel, and may be constructed using a sparse bipartite graph whose vertices can be divided into two disjoint independent sets $U$ and $V$ such that every edge connects a vertex in $U$ to one in $V$. An example of a bipartite graph used for LPDC codes is the so-called Tanner graph. In coding theory, Tanner graphs may also be used to construct longer codes from smaller ones. Both LPDC encoders and LPDC decoders may employ these graphs extensively. The convolutional counterparts of LDPC block codes, LDPC convolutional codes, may be defined by sparse parity-check matrices that allow them to be decoded using a sliding window-based iterative message-passing decoder.

In some embodiments the LPDC (block or convolutional) encoder may be arranged in between the binary-to-ternary converter and the modulator, which means that the LPDC encoder may encode the ternary signal, resulting in a non-binary LPDC encoder. In other words, the LDPC encoder may comprise an input coupled to an output of the binary to ternary converter, and an output coupled to an input of the modulator. The LDPC encoder may be operable or configured to encode the ternary signal at its input to obtain an encoded ternary signal at its output. In such embodiments the entries of a parity-check matrix **H** defining the LDPC block or convolutional code of the LDPC encoder may take values in the Galois field GF(3). Such an arrangement may lead to an optimized coding gain.

According to a further aspect embodiments also provide a receiver corresponding to the transmitter. Hence, the receiver includes a demodulator which is configured or operable to estimate a ternary transmit signal based on a comparison of a received signal with hypothetical modulation symbols from a ternary constellation diagram. Further, the receiver includes a ternary-to-binary converter which is configured or operable to convert the estimated ternary transmit signal to a binary signal.

According to some embodiments the receiver may serve for performing a corresponding receiving method, the method comprising an act of estimating a ternary transmit signal based on a comparison of a received signal with hypothetical modulation symbols from a ternary constellation diagram. Further, the method comprises converting the estimated ternary transmit signal into a binary signal. Embodiments of the receiver may for example be comprised by an optical communications device, such as an optical receiver, which may include further receiver circuitry, such as mixers, Analog-to-Digital Converters (ADCs), demodulators, outer decoders, analog and/or digital signal processors, etc. Consequently, the received signal may have been transmitted via an optical communication channel, such an optical fiber, for example. However, it will be appreciated by the skilled person that embodiments may also be beneficial for other than optical communication systems, such as wireless radio or optical communication systems, for example.

In one or more embodiments the demodulator may be operable to determine two likelihood values per received signal sample. A first likelihood value may be indicative of a ratio of probabilities related to a first hypothetical transmit symbol (tet) and to a second hypothetical transmit symbol (tet). A second likelihood value may be indicative of a ratio of probabilities related to a third hypothetical transmit symbol (tet) and the second hypothetical transmit symbol (tet). In embodiments the first and the second likelihood value may correspond to first and second log-likelihood ratios corresponding to a hypothetical transmit tet.

As some transmitter embodiments may comprise encoders for FEC, some corresponding receiver embodiments may also comprise a decoder configured or operable to decode the binary signal or preferably the estimated ternary transmit signal according to a FEC decoding scheme. In some embodiments the decoder may be a Low-Density Parity-Check (LDPC) block or convolutional decoder.

In one or more embodiments the LPDC (block or convolutional) decoder may be arranged in between the demodulator and the ternary-to-binary converter, which means that the (non-binary) LPDC decoder may operate on the estimated ternary signal. In other words, the LDPC decoder may comprise an input coupled to an output of the demodulator and an output coupled to an input of the ternary-to-binary converter. The LDPC decoder may be configured or operable to decode estimates of encoded ternary symbols (tets) from the demodulator to obtain a decoded ternary signal at its output. In such embodiments the entries of a parity-check matrix $\mathbf{H}$ defining an LDPC block or convolutional code may take values in the Galois field GF(3). Such an arrangement may lead to an optimized decoder performance. The LDPC (block or convolutional) decoder may be an iterative decoder and may be operable to update two log-likelihood ratios per estimated ternary transmit symbol (tet) per decoder iteration.

Some embodiments comprise digital circuitry installed within the transmitters/receivers for performing the respective methods. Such a digital control circuitry, e.g., a digital signal processor (DSP), a Field-Programmable Gate Array (FPGA), an Application-Specific Integrated Circuit (ASIC), or a general purpose processor, needs to be programmed accordingly. Hence, yet further embodiments also provide a computer program having a program code for performing embodiments of the method, when the computer program is executed on a computer or a programmable hardware device.

Some embodiments suggest combining a binary-to-ternary conversion, a non-binary spatially coupled coding scheme over the field GF(3) and a phase-noise-tolerant modulation scheme to enable a near-optimum performance. Embodiments may allow for an increased coding gain and/or a phase-noise tolerant modulation scheme, which allows increasing the reach of (optical) communication systems.

Brief description of the Figures

Some embodiments of apparatuses and/or methods will be described in the following by way of example only, and with reference to the accompanying figures, in which

Fig. 1      illustrates a modulation constrained capacity gain by going from BPSK to 3-PSK;

Fig. 2      illustrates a block diagram a communication system comprising a transmitter and a receiver according to an embodiment;

Fig. 3      shows a possible realization of a 19-bit to 12-tet binary-ternary conversion;

Fig. 4      illustrates a block diagram a communication system comprising a transmitter and a receiver according to a further embodiment;

Fig. 5      illustrates an example of a copy-and-permute operation for a protograph-based LDPC code using a protomatrix $\mathbf{B}$;

Fig. 6      illustrates a visualization of a parity-check matrix obtained by the lifting with a lifting matrix $\mathbf{A}$ obtained from the protograph shown in Fig. 5;

Fig. 7      illustrates a protograph-based Code Design for 3-PSK Spatially-Coupled Codes, corresponding protograph matrix $\mathbf{B}$;

Fig. 8    illustrates a Quasi-Cyclic Parity-Check matrix corresponding to the protograph in Fig. 7 obtained via double lifting with $P$=8 and $S$=512;

Fig. 9    shows four phases of windowed decoding of spatially coupled LDPC convolutional codes;

Fig. 10    illustrates a main module of the layered window-based row decoder for spatially coupled GF(3) codes; double lines represent a vector of two LLRs representing GF(3) entries; and

Fig. 11    illustrates simulation results, possible gains by utilizing 3-PSK instead of BPSK over an AWGN channel.

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the invention. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

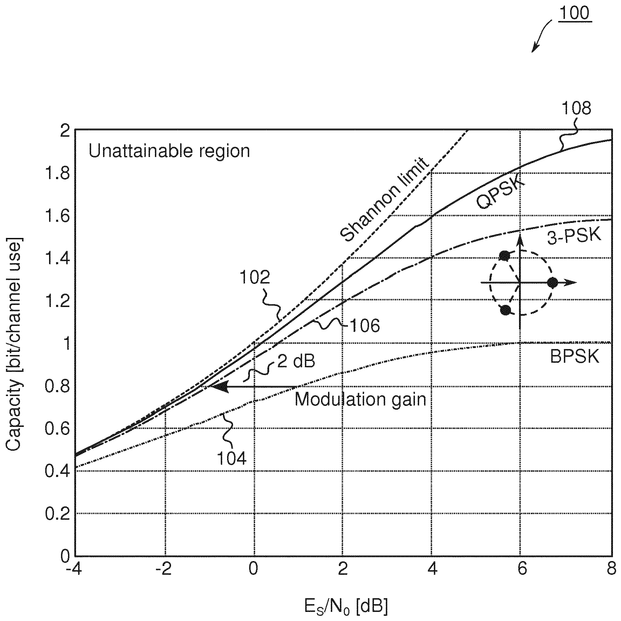

Ultra-long-haul optical communications often target extremely long transmission distances and hence require a receiver to operate at relatively low Signal-to-Noise Ratios (SNRs). For these reasons, often the noise-robust BPSK modulation format is employed. Although BPSK offers significant advantages with respect to hardware implementation, it is far from being perfect from an information theory point of view. If the channel utilization shall be high, i.e., if the number of transmitted bits per channel use approaches one, there is a relatively large gap between the BPSK constrained capacity and the Shannon limit, which is achieved if the channel input is complex Gaussian distributed. This is visualized in diagram 100 of **Fig. 1,** where the Shannon limit 102 and modulation-constrained capacity for some $M$-ary modulation formats is plotted for an additive white Gaussian noise (AWGN) channel. Reference numeral 104 denotes the modulation-constrained capacity for BPSK, reference numeral 106 denotes the modulation-constrained capacity for an embodiment of a proposed ternary modulation format, e.g., 3-PSK, and reference numeral 108 denotes the modulation-constrained capacity for Quadrature Phase-Shift Keying (QPSK).

If we look for instance at a spectral utilization of 0.8 bit/channel use, which corresponds to an allowable Forward Error Correction (FEC) overhead of 25% if we assume e.g., that we transmit 40G Bit/s over two optical (light) polarizations at a symbol rate of 28 GBaud/s with a spectral utilization of 0.8 bit/channel use (25% overhead), we see that the use of a proposed 3-PSK (with three regularly spaced points on the unit circle) modulation scheme, or of higher modulation formats can enable SNR gains of up to 2dB by the use of proper coding.

For that purpose embodiments propose the use of a ternary modulation format, e.g., 3-PSK, as due its simplicity a conventional coherent signal processing part of a receiver can be well adapted. The ternary modulation format is furthermore much more robust to phase noise as the conventional QPSK format.

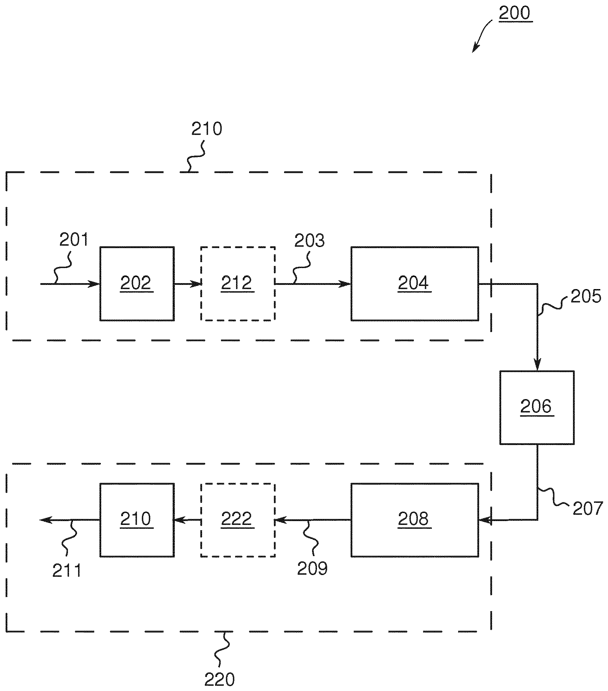

A system model of an exemplary embodiment of a communications system 200 is shown in **Fig. 2.** In the following, we will shortly describe the different blocks of the system model.

The communication system 200 comprises a transmitter 210 and a receiver 220. The transmitter 210 and the receiver 220 are coupled to each other via a communication channel 206. In some embodiments the communication system 200 may be an optical transmission system. Hence, the transmitter 210 may be an optical transmitter; the receiver 220 may be a corresponding optical receiver. The channel 206 may include an optical fiber, for example. Note, however, that embodiments may also be applicable to other communication systems, such as wireless communications, for example.

The transmitter 210 includes a binary-to-ternary converter 202 which is configured to convert a binary input signal 201 (i.e., a base-2 signal) to a ternary signal 203 (i.e., a base-3 signal) comprising ternary digits, also referred to as "tets" in the sequel. In embodiments, the binary-to-ternary converter 202 may correspond to any binary-to-ternary converting unit, binary-to-ternary converter module, etc., including adequate conversion hard- and/or software. Hence, in embodiments the binary-to-ternary converter 202 may contain an input for the binary signal 201, an algorithm, which converts the binary signal 201 to the ternary signal 203, and an output for the ternary signal 203. In some embodiments the converter 202 can be implemented in terms of a computer program and/or a hardware component on which the computer program is executed, such as a DSP, an ASIC, an FPGA or any other processor.

Further, the transmitter 210 includes a modulator 204 which is configured to select, corresponding to the ternary signal 203 or a tet thereof, one or more complex valued modulation or transmit symbols 205 from a ternary constellation diagram. In embodiments, the modulator 204 may correspond to any modulating unit, modulator module, etc., including adequate hard- and/or software. Hence, in embodiments the modulator 204 may contain an input for the ternary signal 203, an algorithm, which converts ternary digits (tets) to complex valued transmit or modulation symbols 205, and an output for the transmit or modulation symbols 205. In some embodiments the modulator 204 can be implemented in terms of a computer program and/or a hardware component on which the computer program is executed, such as a DSP, an ASIC, an FPGA or any other processor.

The transmit or modulation symbols 205 may then be used to modulate one or more carrier signals, for example, in the optical or radio frequency region, for conveying the transmit symbols 205, and hence information, over the communication channel 206 to the associated receiver 220.

In-line with the transmitter 210, the receiver 220 comprises a demodulator 208 which is configured to determine estimates 209 of the ternary transmit signal 203 based on a comparison of a received signal 207 with hypothetical modulation symbols from the ternary constellation diagram. Further, the receiver 220 comprises a ternary-to-binary converter 210 which is configured to convert the estimated ternary transmit symbols 209 to a binary signal 211.

According to some embodiments, the ternary modulation scheme underlying the modulator 204 / demodulator 208 may be a ternary Phase-Shift Keying (PSK) modulation scheme, hence 3-PSK. However, note that also other ternary modulation formats would be possible in principle, such as ternary Amplitude-Shift Keying (ASK) formats (i.e., 3-ASK), ternary Quadrature Amplitude Modulation (3-QAM), or ternary Pulse-Amplitude Modulation (3-PAM), for example.

Thus, some embodiments propose using a 3-PSK modulation format with equidistantly spaced points on the unit circle in the complex I-Q space. The 3-PSK modulation symbols may be given by

$$y \in \left\{ \exp\left( i\left( \frac{2\pi}{3} + O \right) \right), \exp\left( i\left( \frac{4\pi}{3} + O \right) \right), \exp(i(2\pi + O)) \right\} \qquad (1)$$

with O being an arbitrary but fixed phase offset value and $i$ the imaginary unit ($i^2$ = -1). If we assume without loss of generality that $O = 0$, we get, $y \in \{y^{[1]}, y^{[2]}, y^{[3]}\}$, with $y^{[1]} = 1$, $y^{[2]} = \exp(i2\pi/3)$, $y^{[3]} = \exp(i4\pi/3)$. This modulation format may achieve a relatively high robustness against phase noise, as the phase difference between neighboring signal space points is $2\pi/3 = 120°$. This may have advantages with respect to the implementation of a phase estimation circuit in the receiver 220, which may be more robust to large phase noise errors, resulting in a smaller number of phase slips. When transmitting a signal over a transmission channel, the signal's phase may be degraded by a phase offset that may be estimated at the receiver. The phase of a PSK modulated signal may then be corrected by this estimated phase offset. The estimated phase offset may be erroneous to a degree, such that the correction of the received signal causes a rotation of the PSK constellation diagram by a whole numbered multiple of the separation angle from the receiver's perspective. Such a rotation of the constellation diagram occurs from the time instant of one data symbol to a next time instant of a next successive data symbol and is called a phase slip. A typical value for a probability of a phase slip is for example $10^{-3}$.

One 3-PSK modulation symbol 205 (by some abuse of notation also denoted in what follows by *tet*, short for *ternary digit*) can carry the equivalent information of $\log_2(3)$ 1.585 bits. Some embodiments propose to jointly convert $V$ consecutive bits ($b_i, ..., b_{i+V-1}$) into $\lceil V/\log_2(3) \rceil = \lceil V \cdot \log_3(2) \rceil$ tets by a base conversion, as any number can be expressed as $number_{(base)} = \sum_{i=0}^{n} digits_i \times base^i.$ Here $\lceil x \rceil$ denotes the smallest integer larger or equal than $x$. $V$ may be selected such that the ternary overhead $\lceil V/\log_2(3)\rceil - \lceil V/\log_2(3)\rceil$ is minimal. For example, $V$ may be chosen to 19, which is a good choice for $V \leq 64$, and which leads to 12 tets per 19 bits. Another good choice is $V = 11$, mapping 11 bits to $\lceil 6.94\rceil = 7$ tets. Example: $(1000110000000000100)_2$ converts to $(112120022102)_3$. As in decimal representation $2^2+2^{13}+2^{14}+2^{18}=(286724)_{10}= 2 + 1\cdot3^2 + 2\cdot3^3 + 2\cdot3^4 + 2\cdot3^7 + 1\cdot3^8 + 2\cdot3^9 + 1\cdot3^{10}+ 1\cdot3^{11}$.

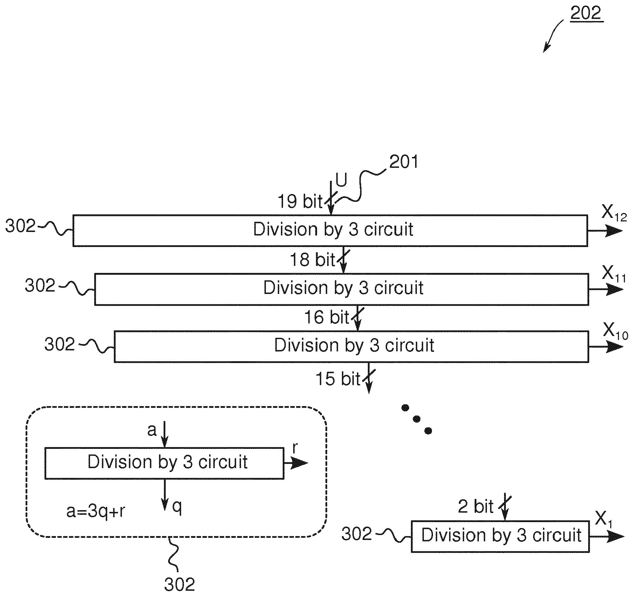

The transmitter's binary-to-ternary converter 202 performing the conversion can be implemented for instance by a concatenation of division-by-3 circuits. An example realization of such a binary-to-ternary conversion circuit which converts a binary signal $u$ having 19 bits to a ternary signal $x$ having 12 tets is shown in **Fig. 3.** The exemplary binary-to-ternary converter 202 comprises a concatenation of multiple division-by-3 blocks 302. An output tet $x$ corresponds to a modulo-3 remainder of the corresponding division-by-3. The single division-by-3 blocks 302 can be realized using a chain of single-bit division circuits based on a simple logic table. Note that throughout the circuit 202, the width of the buses become smaller and thus the width of the divisors also become smaller. Correspondingly, the receiver's ternary-to-binary converter 210 may be performed based on a concatenation of division-by-2 circuits. Depending on the selection of the group parameter $V$, it may happen that not all ternary symbols have the same probability of occurrence. Especially the ternary symbol "2" may have a smaller probability of occurrence than the other two symbols, i.e., $P(X = 2) < P(X = 1)$ and $P(X = 2) < P(X = 0)$. A possible remedy to achieve a uniform distribution of the ternary symbols may be to place an optional ternary scrambler 212 at the output of the binary-to-ternary conversion 202 (and a corresponding optional descrambler 222 at the input of the ternary-to-binary convert at the receiver). Such a scrambler 212 may be based, e.g., on a Pseudo-Random Ternary Sequence (PRTS) s, with the scrambler performing $x_j' \equiv x_j + s_j \bmod 3$.

All ternary operations in the sequel are based on the Galois field GF(3). In the following two tables, the operations "multiplication" and "addition" are listed for the field GF(3):

Table 1: Multiplication and Addition tables for GF(3)

| $a \cdot b$ | 0 | 1 | 2 |
|---|---|---|---|
| 0 | 0 | 0 | 0 |
| 1 | 0 | 1 | 2 |
| 2 | 0 | 2 | 1 |
| $a+b$ | 0 | 1 | 2 |
| 0 | 0 | 1 | 2 |
| 1 | 1 | 2 | 0 |
| 2 | 2 | 0 | 1 |

According to some embodiments, the transmitter 200 may optionally comprise an encoder which is configured to encode either the binary signal 201 or the ternary signal 203 according to a Forward Error Encoding (FEC) scheme prior or upstream to the exemplary 3-PSK modulator 204. In general, any block or convolutional channel encoder could be employed. In some embodiments, however, the encoder may be a Low-Density Parity-Check (LDPC) block or convolutional encoder. In one or more embodiments the encoder may be located upstream to the binary-to-ternary converter 202, while in other embodiments the encoder may be located downstream to the binary-to-ternary converter 202. In the first case the encoder would operate on binary signals, while in the latter case the encoder would operate on ternary signals. For possibly optimum coding gains the latter implementation may be preferred in conjunction with the proposed ternary modulation format.

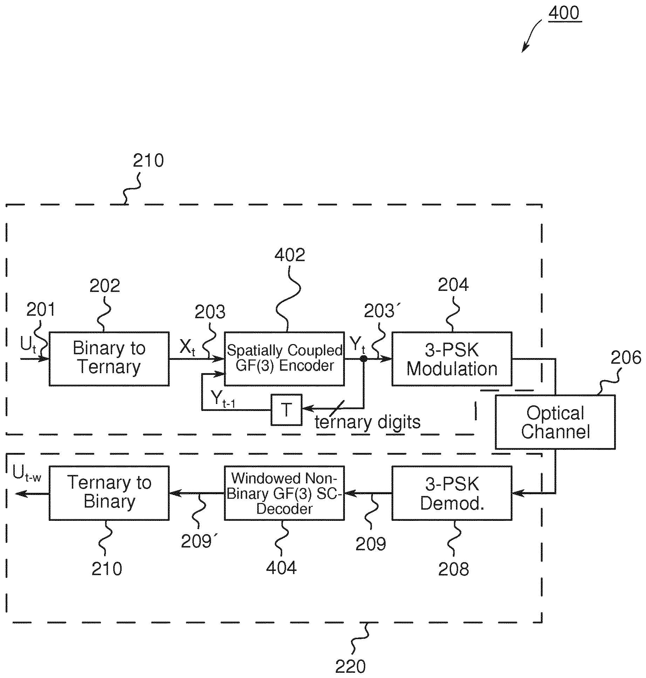

A resulting exemplary communication system 400 is illustrated in **Fig. 4.**

Compared to Fig. 2 the exemplary transmitter 210 of Fig. 4 additionally comprises a spatially coupled encoder 402 in between the binary-to-ternary converter 202 and the 3-PSK modulator 204. In the following the spatially coupled encoder 402 will also be denoted as LDPC convolutional encoder. The LDPC convolutional encoder 402 comprises an input coupled to an output of the binary to ternary converter 202 and an output coupled to an input of the modulator 204. Further, the LDPC convolutional encoder 402 is operable to encode the ternary signal 203 at its input to obtain an encoded ternary signal 203' at its output. The encoded ternary signal 203' is fed to the modulator 204 and mapped to ternary modulation symbols 205. Note that in other embodiments the LDPC convolutional encoder 402 could also be replaced by an LDPC block encoder, for example.

Consequently, the corresponding receiver 220 of the exemplary system of Fig. 4 comprises an LDPC block or convolutional decoder 404, which is positioned in between the exemplary 3-PSK demodulator 208 and the ternary-to-binary converter 210 comprising eventually a descrambler that is configured to correspond to the scrambler at the transmitter. The LDPC decoder 404 comprises an input coupled to an output of the demodulator 208, an output coupled to an input of the ternary to binary converter 210. Further the LDPC decoder 404 is operable to decode estimates of encoded ternary symbols 209 coming from the demodulator 208 to obtain a decoded ternary signal 209' at its output.

For a better understanding of embodiments of the present invention a short introduction to LDPC block and convolutional codes and some related decoding algorithms will be provided in the following.

An LDPC (block) code may be defined by a sparse parity-check matrix **H** of dimension $M \times N$, where $N$ is the LDPC code word length (in symbols) of the LDPC code and $M$ denotes the number of parity symbols. The rows of a parity-check matrix are parity checks on the code words of a code. That is, they show how linear combinations of certain symbols of each code word equal zero. Usually, the number of information symbols equals $M$-$N$. The design rate of the code amounts to $r = (N-M)/N$. The overhead of the code is defined as OH = $1/r$ - 1 = $M/(N-M)$. Sparse means that the number of non-zero entries in **H** is small compared to the number of zero entries. Practical LDPC codes usually have a fraction of non-zero entries that is below 1% by several orders of magnitude.

We start by introducing some notation and terminology related to LDPC codes. Each column of the parity-check matrix **H** corresponds to one symbol (e.g., one bit or one tet) of a Forward Error Correction (FEC) frame or LPDC code word. As LDPC codes can also be represented in a graphical structure called Tanner graph (which we will not introduce here), the columns of **H** and thus the FEC frame (LPDC code word) symbols are sometimes also called variable nodes, referring to the graph-theoretic representation. Similarly, each row of **H** corresponds to a parity-check equation and ideally defines a parity symbol, if **H** has full rank. For example, the rank can be defined as the column rank. The column rank of a matrix **H** is the maximum number of linearly independent column vectors of **H**. Correspondingly, row rank of **H** is the maximum number of linearly independent row vectors of **H**. Owing to the Tanner graph representation, the rows of **H** are associated to so-called check nodes. Note that the row rank and the column rank of a matrix **H** are always equal, which is a well-known result in linear algebra.

In order to describe an exemplary LDPC encoder/decoder we introduce some additional notation. First, we denote by **x** the vector of $K = N - M$ information symbols. The single elements of **x** are denoted by $x_i$, i.e., $\mathbf{x} = (x_1, x_2, ..., x_i, ..., x_K)^T$. After encoding with an exemplary LDPC encoder 402, the LDPC code word 209' $\mathbf{y} = (y_1, y_2, ..., y_N)^T$ of length $N$ results. We denote by $y_i$, the single symbols (e.g., tets) of the code word **y.** The LDPC code is said to be systematic if the information vector **x** is included in the code word, e.g., if $\mathbf{y} = (x_1,..., x_K, p_1, ... p_M)^T$, with $\mathbf{p} = (p_1, ..., p_M)^T$ denoting the vector of $M$ parity symbols. Furthermore, let the set $\mathcal{N}(m)$ denote the positions of the non-zero entries in the $m$-th row of **H,** i.e., $\mathcal{N}(m) = \{i: H_{m,i} \neq 0\}.$ A vector **y** is a code word of the LDPC code defined by **H,** if **Hy = 0,** with the additions defined over the respective ternary or binary field (addition modulo-3, or XOR, respectively). The set of code words is thus defined to be the null space of **H.** This signifies that the product of each row of **H** and **y** is zero, or

$$\sum_{j \in \mathcal{N}(m)} y_j = 0,$$
for all $m$ with $1 \leq m \leq M$.

Let us illustrate the concept of LDPC codes by a binary "toy" example which we subsequently extend to the GF(3) case. This example defines a parity-check matrix **H** of two concatenated (4, 5) single parity-check codes, separated by a $4 \times 5$ block-interleaver. The exemplary binary parity-check matrix **H** of dimension $9 \times 25$ is given by

$$\mathbf{H} = \begin{pmatrix} 1 & 1 & 1 & 1 & & & & & & & & & & & & & 1 & & & & & & & & \\ & & & & 1 & 1 & 1 & 1 & & & & & & & & & & 1 & & & & & & & \\ & & & & & & & & 1 & 1 & 1 & 1 & & & & & & & 1 & & & & & & \\ & & & & & & & & & & & & 1 & 1 & 1 & 1 & & & & 1 & & & & & \\ 1 & & & & 1 & & & & 1 & & & & 1 & & & & & & & & 1 & & & & \\ & 1 & & & & 1 & & & & 1 & & & & 1 & & & & & & & & 1 & & & \\ & & 1 & & & & 1 & & & & 1 & & & & 1 & & & & & & & & 1 & & \\ & & & 1 & & & & 1 & & & & 1 & & & & 1 & & & & & & & & 1 & \\ & & & & & & & & & & & & & & & & 1 & 1 & 1 & 1 & & & & & 1 \end{pmatrix}.$$

Note that for simplicity reasons only 1s are illustrated in the parity-check matrix **H** above. Thus, $M = 9$, $N = 25$, and the code has an overhead of 56% (given by $M/(N-M)$) or a rate of $r = 0.64$, equivalently. We have

$\mathcal{N}(1) = \{1; 2; 3; 4; 17\}$, $\mathcal{N}(2) = \{5; 6; 7; 8; 18\}$, $\mathcal{N}(3) = \{9; 10; 11; 12; 19\}$, $\mathcal{N}(4) = \{13; 14; 15; 16; 20\}$, $\mathcal{N}(5) = \{1; 5; 9; 13; 21\}$, $\mathcal{N}(6) = \{2; 6; 10; 14; 22\}$, $\mathcal{N}(7) = \{3; 7; 11; 15; 23\}$, $\mathcal{N}(8) = \{4; 8; 12; 16; 24\}$, $\mathcal{N}(9) = \{17; 18; 19; 20; 25\}$. This means for

instance that we have, if we use **H** for describing a binary code, (using the first row of **H**) $y_1+y_2+y_3+y_4+y_{17}=0$, or, if the code is systematic, $x_1+x_2+x_3+x_4+p_1=0$, i.e., $p_1=x_1+x_2+x_3+x_4$, defines the first parity bit. If we extend this example to the ternary case, we have to replace the non-zero entries of **H** with non-zero entries taken from the non-zero elements of GF(3). If we randomly choose the non-zero elements, this leads to the exemplary matrix

$$\mathbf{H}_{nb} = \begin{pmatrix} 1 & 2 & 2 & 1 & & & & & & & & & 1 & & \\ & & 2 & 2 & 1 & 1 & & & & & & & & 1 & \\ & & & & 1 & 1 & 2 & 1 & & & & & & & 1 \\ & & & & & & 2 & 1 & 2 & 2 & & & 2 & & \\ 2 & & & 1 & & & 2 & & & 1 & & & & 2 & \\ 1 & & & & 1 & & & 2 & & & 2 & & & & 1 \\ & 2 & & & 1 & & & 2 & & & 1 & & & 2 & \\ & 1 & & & 1 & & & 2 & & & 1 & & & & 2 \\ & & & & & & & & 1 & 1 & 2 & 1 & & & 1 \end{pmatrix}$$

Returning to our running example with the first row of $\mathbf{H}_{nb}$, this means that the equation $y_1+2y_2+2y_3+y_4+y_{17} \equiv 0 \bmod 3$ has to be fulfilled. Similary we find then in the systematic case that $p_1 \equiv x_1+2x_2+2x_3+x_4 \bmod 3$, with $x_1$, $x_2$, $x_3$, $x_4$ elements from GF(3) given by the information sequence.

While in the 1960s and the following decades, most coding research focused on block coding techniques, many practical coding schemes were based upon convolutional codes. With the advent of turbo codes and the rediscovery of LDPC codes, this suddenly changed such that nowadays most new coding schemes are again block codes. The trend is, however, to return back to convolutional-like structures.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the Maximum A Posteriori (MAP) thresholds of the underlying ensemble. Thus, contrary to a common belief, introducing structure into LDPC codes leads to a class of (degenerated) realizations of LDPC codes which show superior performance under belief propagation decoding. This effect of threshold saturation by introducing structure has been analyzed for the Binary Erasure Channel (BEC) and it has been shown that spatially coupled LDPC codes can asymptotically achieve the MAP threshold of the underlying regular ensemble under belief propagation decoding. Recently, this result has been extended to more general channels and it has been shown that spatially coupled ensembles universally achieve capacity over binary-input memoryless symmetric-output channels: most codes of this ensemble are good for each channel realization of this class of channels.

For simplicity, we exemplarily consider time-independent LDPC convolutional codes. Hence, the encoder 402 may be an LDPC block or convolutional encoder. Instead of being a block code of dimension $N$ with parity-check matrix **H,** an LDPC convolutional code has an infinitely extended parity-check matrix $\mathbf{H}_{conv}$, which has the following form

$$\mathbf{H}_{conv} = \begin{pmatrix} \ddots & & & & & \\ \ddots & \mathbf{H}_0 & & & & \\ \vdots & \mathbf{H}_1 & \mathbf{H}_0 & & & \\ \ddots & \vdots & \mathbf{H}_1 & \mathbf{H}_0 & & \\ & \mathbf{H}_\mu & \vdots & \mathbf{H}_1 & \ddots & \\ & & \mathbf{H}_\mu & \vdots & \ddots & \\ & & & \mathbf{H}_\mu & \vdots & \\ & & & & \ddots & \end{pmatrix}_\infty .$$

Thereby the value $\mu$ is commonly called the syndrome former memory, in analogy to convolutional codes. For simplicity only, we look in the remainder of this specification at the case $\mu = 1$, leading to

$$\mathbf{H}_{conv} = \begin{pmatrix} \ddots & & & & & \\ \ddots & \mathbf{H}_0 & & & & \\ & \mathbf{H}_1 & \mathbf{H}_0 & & & \\ & & \mathbf{H}_1 & \mathbf{H}_0 & & \\ & & & \mathbf{H}_1 & \ddots & \\ & & & & \ddots \end{pmatrix}_{\infty} .$$

Note, however, that embodiments also comprise implementations with values of $\mu$ other than 1, e.g., $\mu = 0$ (leading to an LDPC block code) or $\mu > 1$. We see that $\dim(\mathbf{H}_0) = \dim(\mathbf{H}_1) = M \times N$ has to hold. Note that in practical systems, the code is usually terminated. For optical communication systems, which may usually be implemented in a stream-like mode, it is convenient to terminate the code only at the beginning of a transmission (or at the beginning of a super-frame) and thus we may consider left-terminated codes with the parity-check matrix

$$\mathbf{H}_{conv} = \begin{pmatrix} \mathbf{H}_0 & & & & & \\ \mathbf{H}_1 & \mathbf{H}_0 & & & & \\ & \mathbf{H}_1 & \ddots & & & \\ & & \ddots & \mathbf{H}_0 & & \\ & & & \mathbf{H}_1 & \mathbf{H}_0 & \\ & & & & \mathbf{H}_1 & \ddots \\ & & & & & \ddots \end{pmatrix}_{\infty}$$

This termination has a crucial effect on the performance and is responsible for the outstanding asymptotic performance of this class of codes.

Further, we consider a protograph-based construction of spatially coupled (also commonly called terminated convolutional) LDPC codes. Thereby a protograph is a convenient way of describing LDPC codes. Protograph codes are constructed from a so-called $P$-cover of a relatively small graph which conveys the main properties of the code. In contrast to the graph representation of the LDPC code, the protograph may contain multiple edges between variable and check nodes. The code itself is constructed by placing $P$ copies of the protograph next to each other (note that these have no interconnecting edges) and permuting the edges between the different copies of the protograph, such that the relation between the group of edges is respected.

This copy-and-permute operation for a protograph may be described by a protomatrix. An example of such a protomatrix is

$$\mathbf{B} = \begin{pmatrix} 1 & 2 & 0 \\ 2 & 1 & 3 \end{pmatrix}$$

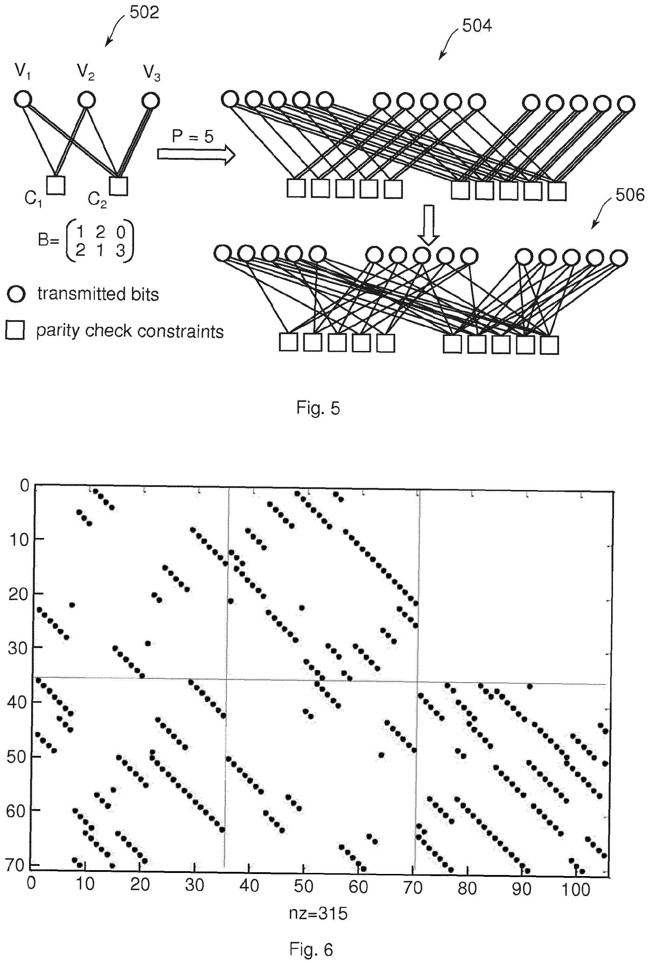

where the numbers or symbols in **B** denote the amount of parallel edges between the entries in the graph. Note that the permutation may be performed such that no parallel edges remain in the graph after permuting. **Fig. 5** shows an example of the copy-and-permute operation for generating a graph with $P=5$ using the example protomatrix **B.**

In Fig. 5 reference numeral 502 denotes a template graph, i.e., the protograph, for the protomatrix **B.** According to the entries of the first row **of B** there is one edge connecting variable node $v_1$ to check node $c_1$. Two edges are connecting variable node $v_2$ and check node $c_1$. Zero edges are between variable node $v_3$ and check node $c_1$. According to the entries of the second row of **B** there are two edges connecting variable node $v_1$ to check node $c_2$. One edge is connecting variable node $v_2$ and check node $c_2$. Three edges are between variable node $v_3$ and check node $c_2$. Reference numeral 504 denotes the graph resulting of the copy-operation with $P=5$ using protomatrix **B.** Finally, reference numeral 506 denotes the graph resulting of the permute-operation based on graph 504.

Most LDPC codes that are implemented today are so-called Quasi-Cyclic (QC) LDPC codes. They have a parity-check matrix **H** with a structure that allows for inherent paral-lelization of the LDPC decoder 404 and leads to an efficient encoder realization. Almost all LDPC codes utilized in practice belong to the class of QC-LDPC codes.

QC-LDPC codes may be constructed using a so-called lifting matrix **A**. The parity-check matrix **H** may be constructed from the lifting matrix **A** by replacing each element of **A** with either an all-zero matrix of size $S \times S$ or a permutation matrix, e.g., a cyclically permuted identity matrix, of size $S \times S$. We adhere to the following notation: S denotes the lifting factor, i.e., the size of the all-zero or cyclically shifted identity matrix. If the entry of **A** at row $m$ and column $i$ corresponds to a predetermined value, e.g., $A_{m,i} = -1$, then the all-zero matrix of size $S \times S$ is used, and if $A_{m,i} \geq 0$, $A_{m,i}$ may denote how many cyclic right shifts of the identity matrix are performed. If dim(**H**) = $M \times N$, then dim(**A**) = $M' \times N'$, with $M'=M/S$ and $N'=N/S$. We furthermore define the set $\mathcal{N}_{\mathbf{A}}(m)$ to denote the positions of the non "-1" entries (or any other entry denoting a void replacement) in the $m$-th row of **A**, i.e., $\mathcal{N}_{\mathbf{A}}(m) = \{i: A_{m,i} \neq -1\}$.

Let us illustrate the construction of QC-LDPC codes by a small (artificial) example with a lifting matrix of size dim(**A**) $=3 \times 5$ and a lifting factor of $S = 5$ (leading to dim(**H**) = $S \cdot$dim(**A**) = $15 \times 25$). This corresponds to a code of design rate $r = 0.4$, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} = $$

Note that for the sake of clarity again only non-zero entries are show in the description of **H.** Note that **H** represents a binary matrix. The extension to the ternary matrix can be achieved by replacing the non-zero elements by according non-zero elements of GF(3). Note that a matrix with all the non-zero elements being "1" is also a valid GF(3) matrix. Generally the value $S$ corresponds to the parallelism that can be implemented in a QC-LDPC decoder 404.

In order to realize protograph-based QC-LDPC codes, we may employ a double-lifting procedure. First, from the protomatrix **B**, we may generate by the copy-and-permute operation a lifting matrix **A** and then optimize the non-void entries of **A** in order to get desired code properties. Using this lifting matrix **A,** we can then construct the parity-check-matrix **H** with the desired properties. We thus have dim(**H**) = $M''SP \times N''SP$, with dim(**B**)=$M'' \times N''$.

Let us illustrate the generation of an exemplary parity-check matrix **H** of a protograph-based QC-LDPC based on two-fold lifting by means of an example with $P$=5 and $S$=7. We start with the same exemplary protomatrix

$$\mathbf{B} = \begin{pmatrix} 1 & 2 & 0 \\ 2 & 1 & 3 \end{pmatrix},$$

which has been already introduced above and illustrated in Fig. 5. The $P$=5 cover shown in Fig. 5 of matrix **B** leads to a (parity-check) matrix **H'** that may be described by

$$\mathbf{H'} = \begin{pmatrix} 1 & & & & 1 & 1 & & & & & & \\ & & & 1 & 1 & & & 1 & & & & \\ & & 1 & & 1 & & & & 1 & & & \\ 1 & & & & & 1 & & & 1 & & & \\ & 1 & & & & & 1 & 1 & & & & \\ 1 & & & & 1 & & 1 & & & 1 & 1 & 1 \\ 1 & & 1 & & & & & & 1 & & 1 & & 1 & 1 \\ & 1 & 1 & & 1 & & & & & & & 1 & 1 & 1 \\ 1 & & & 1 & & 1 & & & & 1 & 1 & & 1 \\ 1 & 1 & & & & & 1 & & 1 & & & 1 \end{pmatrix}.$$

The bipartite graph 506 of the matrix **H'** is shown in the bottom right corner of Fig. 5. Note that the $P \times P$ squares of **H'** are filled with non-overlapping superpositions of permutation matrices preserving the number of "1"s per row and column of each $P \times P$ submatrix. Using the matrix **H'**, we can get the lifting matrix **A** by properly selecting the cyclic shifts. An exemplary lifting matrix **A** is

$$\mathbf{A} = \begin{pmatrix} -1 & 3 & -1 & -1 & -1 & -1 & 5 & 5 & -1 & -1 & -1 & -1 & -1 & -1 & -1 \\ -1 & -1 & -1 & -1 & 0 & 3 & -1 & -1 & 0 & -1 & -1 & -1 & -1 & -1 & -1 \\ -1 & -1 & -1 & 2 & -1 & 1 & -1 & -1 & -1 & 0 & -1 & -1 & -1 & -1 & -1 \\ 6 & -1 & -1 & -1 & -1 & -1 & 6 & -1 & -1 & 3 & -1 & -1 & -1 & -1 & -1 \\ -1 & -1 & 6 & -1 & -1 & -1 & -1 & 4 & 2 & -1 & -1 & -1 & -1 & -1 & -1 \\ 0 & -1 & -1 & -1 & 0 & -1 & -1 & 2 & -1 & -1 & 5 & 4 & 6 & -1 & -1 \\ 4 & -1 & -1 & 1 & -1 & -1 & -1 & -1 & -1 & 1 & -1 & 2 & -1 & 0 & 5 \\ -1 & -1 & 1 & 0 & -1 & 0 & -1 & -1 & -1 & -1 & -1 & -1 & 6 & 6 & 6 \\ -1 & 4 & -1 & -1 & 0 & -1 & 4 & -1 & -1 & -1 & 2 & 0 & -1 & 6 & -1 \\ -1 & 2 & 1 & -1 & -1 & -1 & -1 & -1 & 5 & -1 & 0 & -1 & 0 & -1 & 3 \end{pmatrix},$$

where the Is of **H'** have been replaced by shift values in the range $\{0,1,...,S\text{-}1\}$ (here $S=7$) and the 0s (not shown in the description of **H'** for clarity) have been replaced by "-1". The resulting exemplary parity-check matrix **H** has dimension $2PS \times 3PS = 70 \times 105$ and is visualized in **Fig. 6,** with the single dots representing the non-zero elements of the matrix.

In order to construct an exemplary spatially coupled protograph-based LDPC code used to achieve a channel utilization of approximately 0.8 bit/channel use with the proposed 3-PSK modulation scheme, we may generate exemplary $\mathbf{H}_0$ and $\mathbf{H}_1$ using the following exemplary protographs $\mathbf{B}_0$ and $\mathbf{B}_1$:

$$\mathbf{B}_0 = \begin{pmatrix} 2 & 1 \end{pmatrix}$$

$$\mathbf{B}_1 = \begin{pmatrix} 2 & 3 \end{pmatrix}$$

This may lead to the exemplary protograph $\mathbf{B}_{conv}$ defining an embodiment of a spatially coupled/convolutional LDPC code underlying the encoder and decoder modules 402 and 404, respectively. Note that the right element of $\mathbf{B}_0$ is 1 in some embodiments.

$$\mathbf{B}_{conv} = \begin{pmatrix} 2 & 1 & & & & & & & \\ 2 & 3 & 2 & 1 & & & & & \\ & & 2 & 3 & 2 & 1 & & & \\ & & & & 2 & 3 & 2 & 1 & \\ & & & & & & 2 & 3 & 2 & 1 \\ & & & & & & & \ddots & \ddots & \ddots & \ddots \end{pmatrix}$$

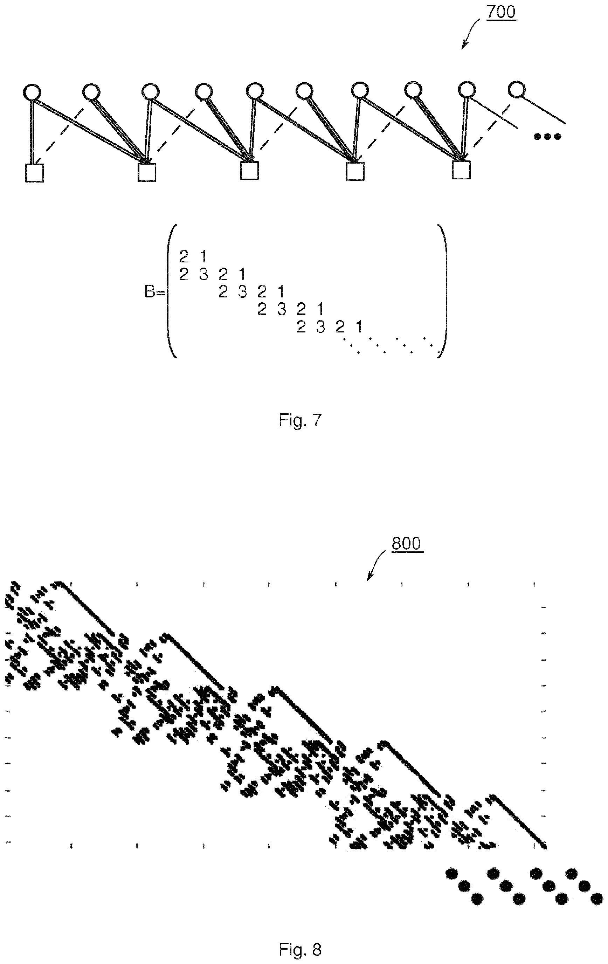

A protograph 700 corresponding to this exemplary protomatrix is shown in **Fig. 7.** The edges corresponding to a "1" in the protomatrix $\mathbf{B}_{conv}$ are marked by dashed lines in Fig. 7. The reason for this is the following: We do not permute these edges in the copy-and-permute operation and in the lifting process to generate the QC-code. We replace these edges corresponding to a "1" in the protomatrix $\mathbf{B}_{conv}$ by an identity matrix. This structure may facilitate encoding. The resulting exemplary parity-check matrix $\mathbf{H}$ for the (practically more relevant) exemplary parameters $P$=8 and $S$=512 is shown in **Fig. 8** and denoted by reference numeral 800. As the convolutional LDPC code of encoder 402 may be non-binary, the entries in $\mathbf{H}$ are not 0 and 1, as in a binary code, but instead, they may take values in GF(3), i.e., 0, 1, or 2. Hence, the entries of a parity-check matrix $\mathbf{H}$ defining an LDPC block or convolutional code of the LDPC encoder 402 may take values in the Galois field GF(3). We may thus replace the values in $\mathbf{H}$ by either 1 or 2 from GF(3). This can be done either randomly or according to an adequately chosen pattern simplifying the implementation of the decoder.

The exemplary parity-check matrix $\mathbf{H}$ shown in Fig. 8 has been obtained by the protomatrix $\mathbf{B}_{conv}$ using the double lifting with $P$=8 and $S$=512 where the shifts have been optimized in order to avoid harmful structures that can lead to decoding failures. In addition, the "1" entry on the upper diagonal, i.e., the "1" entry of $\mathbf{B}_0$, has not been lifted using random permutation matrices but using an identity matrix. This has the advantage that encoding may be largely simplified. We can observe that the matrix 800 shown in Fig. 8 has the same structure than the matrix

$$\mathbf{H}_{conv} = \begin{pmatrix} \ddots & & & & \\ \ddots & & & & \\ \ddots & \mathbf{H}_0 & & & \\ & \mathbf{H}_1 & \mathbf{H}_0 & & \\ & & \mathbf{H}_1 & \mathbf{H}_0 & \\ & & & \mathbf{H}_1 & \ddots \\ & & & & \ddots \end{pmatrix}_{\infty} .$$

The encoding of the exemplary matrix 800 based on this structure is described in the next section.

The encoder 402 of the LDPC convolutional code with $m$ = 1 and parity-check matrix $\mathbf{H}_{conv}$ is also shown in Fig. 4. Here, a block of information tets $\mathbf{x}_t$ 203 (note that we include time indices to stress the dependence on previous frames) may be encoded using $\mathbf{H}_0$ and $\mathbf{H}_1$ together with the previously encoded block $\mathbf{y}_{t-1}$ yielding a block of encoded tets $\mathbf{y}_t$ 203'. The size of each block of encoded tets $\mathbf{y}_t$ 203' amounts $N$, with dim($\mathbf{H}_0$)=dim($\mathbf{H}_1$) = $M \times N$. As $\mathbf{H}_0$ has the structure with the single identity matrix on the right hand part (stemming from the "1" entry of $\mathbf{B}_0$), the encoding is trivial: each parity tet, with the position of the parity tet corresponding to the positions of the identity matrix, is directly given from the incoming information tets $\mathbf{x}_t$ and the tets of the previously encoded block $\mathbf{y}_{t-1}$. If we define $\mathbf{H}_0 = [\mathbf{H}_{0,s}\ \mathbf{I}]$ with $\mathbf{I}$ denoting the identity matrix and if we define the sets

$$\mathcal{N}_1(m) = \{i : \mathrm{H}_{1,m,i} \neq 0\}$$

$$\mathcal{N}_{0,s}(m) = \{i : \mathrm{H}_{0,s,m,i} \neq 0\}$$

that contain the positions of the non-zero entries of $\mathbf{H}_0$ and $\mathbf{H}_{1,s}$ for row m respectively. Let $\mathcal{N}_{1,i}(m)$ denote the $i$'th entry of $\mathcal{N}_1(m)$ and $\mathcal{N}_{0,s,i}(m)$ the $i$'th entry of $\mathcal{N}_{0,s}(m)$. The generation of ternary parity digit $p_m$ ($1 \leq m \leq$ M) can be described by

$$p_m \equiv \sum_i H_{1,m,\mathcal{N}_{1,i}}(m) y_{t-1,\mathcal{N}_{1,i}}(m) + \sum_j H_{0,s,m,\mathcal{N}_{0,s,j}}(m) x_{t,\mathcal{N}_{0,s,j}}(m) \bmod 3 .$$

Note that in principle every ternary parity digit can be computed in parallel. At least S parity digits can be computed in parallel by fetching always blocks of *S* data digits and by using respective shifter circuits. Note that this structure also has the advantageous side effect that the parity-check matrix has full (row) rank.

In conventional binary (convolutional) LDPC codes, the entries of the sparse parity-check matrix **H** are 0 or 1. In the exemplary non-binary case, other values are also possible. In the GF(3) case we are considering, valid entries of the parity-check-matrix **H** are 0, 1, or 2, with probabilities $P(H_{i,j} = 0) > P(H_{i,j} \in \{1,2\})$. In embodiments we may select $P(H_{i,j}=1) = P(H_{i,j}=2)$, i.e., the elements 1 and 2 may occur equiprobably. Very good performance can be obtained if we just randomly select the non-zero elements to be either 1 or 2, e.g., according to a Bernoulli distribution. The encoder 402 and decoder 404 can then be realized using for instance synchronized random number generators (that can be implemented using simple shift registers) to generate the non-zero entries. More deterministic constructions are also possible, however, one has to be careful to select one construction that leads to a good performance (which can be verified using Monte-Carlo simulations).

As some embodiments propose to use a 3-PSK modulation format with equidistantly spaced points on the unit circle in the complex I-Q space, the modulation symbols 205 are given by $y \in \{\exp(i(2\pi/3+O)), \exp(i(4\pi/3+O)), \exp(i(2\pi+O))\}$, with *O* being an arbitrary but fixed offset factor. If we assume without loss of generality that *O* = 0, we get, $y \in \{y^{[1]}, y^{[2]}, y^{[3]}\}$, with $y^{[1]} = 1$, $y^{[2]}=\exp(i2\pi/3)$, $y^{[3]}=\exp(i4\pi/3)$. This exemplary 3-PSK modulation format has a relatively high robustness against phase noise, as the phase difference between neighboring signal space points is $2\pi/3 = 120°$. This has advantages with respect to the implementation of the phase estimation circuit in the receiver, which will be more robust to large phase noise errors, resulting in a smaller number of phase slips.

The input to the receiver's decoder 404 after demodulation in demodulator module 208 may be described as a vector of log-likelihood ratios for the 3-PSK symbols or tets

$$\mathbf{L}(z) = \begin{pmatrix} L_1(z) & L_2(z) \end{pmatrix}$$
$$= \left( \ln\left( \frac{p(z \mid y = 1)}{p(z \mid y = 0)} \right) \quad \ln\left( \frac{p(z \mid y = 2)}{p(z \mid y = 0)} \right) \right) .$$

That is to say, in one or more embodiments the demodulator 208 may be configured to determine two likelihood values $L_1(z)$ and $L_2(z)$ per received signal sample *z*. A first likelihood value $L_1(z)$ may be indicative of a ratio of probabilities related to a first hypothetical transmit symbol (tet) *y* = 1 and a second hypothetical transmit symbol (tet) *y* = 0. A second likelihood value $L_2(z)$ may be indicative of a ratio of probabilities related to a third hypothetical transmit symbol (tet) *y* = 2 and the second hypothetical transmit symbol (tet) *y* = 0, for example. In embodiments the first and the second likelihood value may correspond to first and second log-likelihood ratios corresponding to a hypothetical transmit tet.

The above probability quantities $p(z \mid y)$ may be directly computed from the ternary signal space set using an assumed noise distribution. Usually an AWGN distribution may be assumed, which simplifies the expressions and which occurs frequently in practice, especially in the context of coherent optical transmission systems. From **L**(z), the conditional probabilities may be recovered by

$$p(z \mid y = 0) = \frac{1}{1 + \exp(L_1(z)) + \exp(L_2(z))}$$

$$p(z \mid y = 1) = \frac{\exp(L_1(z))}{1 + \exp(L_1(z)) + \exp(L_2(z))} .$$

$$p(z \mid y = 2) = \frac{\exp(L_2(z))}{1 + \exp(L_1(z)) + \exp(L_2(z))}$$

According to some embodiments, the LDPC convolutional decoder 404 may employ a sliding window decoding scheme to recover the transmitted ternary and LDPC convolutional enoded information sequences. Hence, the decoder 404 may operate on a window of *w* copies of the row defining matrix $[\mathbf{H}_1 \; \mathbf{H}_0]$. It is proposed to combine a windowed decoding together with a row-decoding or layered decoding algorithm. The windowed decoding scheme has been introduced in A. Iyengar et al., "Windowed decoding of protograph-based LDPC convolutional codes over erasure channels," 2011, and the layered decoding scheme, which may speed up the convergence of the decoder 402, has been introduced in D. E. Hocevar, "A Reduced Complexity Decoder Architecture via Layered Decoding of LDPC Codes," in Proc. IEEE Workshop on Signal Processing Systems (SIPS), 2004.

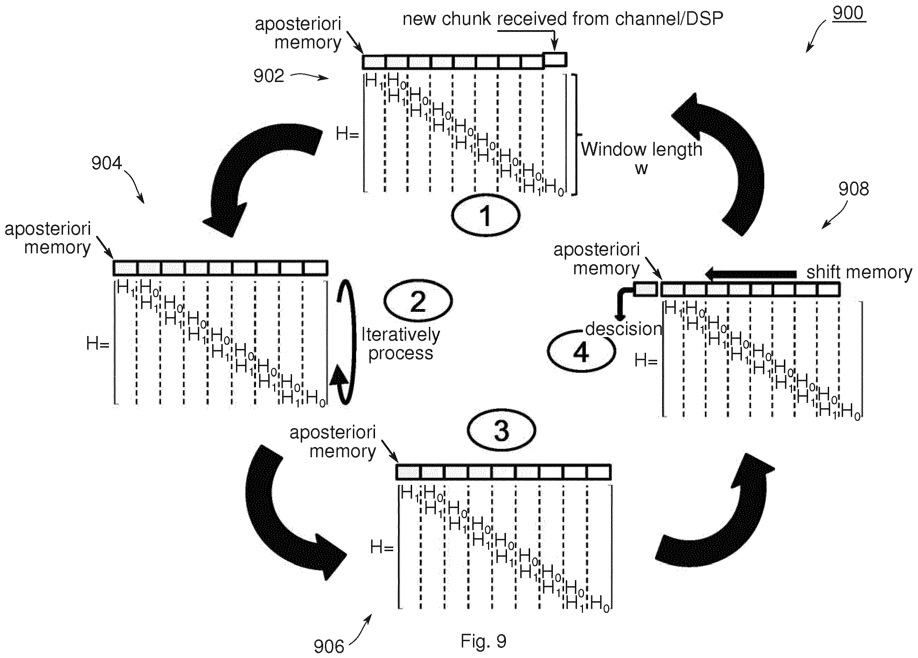

The layered decoding algorithm continuously updates and refines the received LLR values $\mathbf{L}(z)$, i.e., two likelihood values $L_1(z)$ and $L_2(z)$ per received signal sample $z$, with the goal to compute LLRs that approximate Maximum A Posteriori (MAP) values. Four exemplary cycles of the windowed decoder 404 are depicted in **Fig. 9** for an example with window size $w = 8$.

The windowed decoder 404 makes use of an a posteriori memory of size $(w+\mu)N$, with $N = \text{columns}(\mathbf{H}_0) = \text{columns}(\mathbf{H}_1)=N''SP$. In a first step 902 of the illustrated cycle 900 a new chunk (size $N$) of received LLRs at time instant $t$ is received and inserted into an appropriate position of the decoder's a-posteriori memory. In a second step 904, a predefined number of decoder iterations may be executed making use of the row defining matrix $[\mathbf{H}_1\ \mathbf{H}_0]$. Note that the row decoder algorithm can be designed for this matrix $[\mathbf{H}_1\ \mathbf{H}_0]$ and then can be reused by just accessing appropriately shifted memory locations. The different shades of grey in a third step 906 indicate reliabilities of different chunks of received LLRs in the a posteriori memory. It can be observed that the reliabilities increase from right to left, i.e., the oldest values having received the highest number of updates, have the largest reliability. In a fourth step 908 of the cycle 900, the a posteriori memory is shifted and the left-most LLR chunk is forward to a hard decision circuit in order to recover hypothetically transmitted tets. After the shifting, there is now room for a new chunk that can be inserted in the first step 902 of the next cycle.

Note that the windowed decoding algorithm introduces a decoding delay of $w+\mu-1$ frames, such that at time instant $t$, we can recover the information frame $\mathbf{x'}_{t-w-\mu+1}$. This is however of no issue in an optical communication system operating in a streaming fashion. Note that at the beginning the convolutional like encoder 402 may be initialized with zeros at its second input (labeled with $\mathbf{y}_{t-1}$). If the transmission starts at $t = 0$, this means that we set $\mathbf{y}_{-1}=\mathbf{0}$. Accordingly, the memory of the decoder 404 may be initialized with perfect knowledge about the initial tets being zero $(-\infty,-\infty)$.

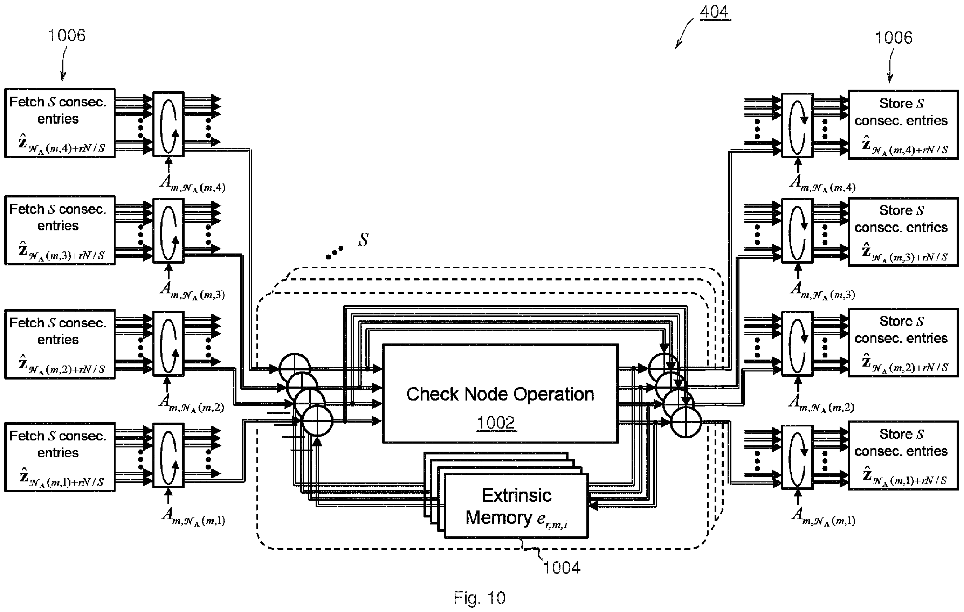

Let the set $\mathcal{N}_\mathbf{A}(m)$ denote the positions of the non "-1" entries (or any other entry denoting a void replacement) in the $m$-th row of $\mathbf{A}$, i.e., $\mathcal{N}_\mathbf{A}(m) = \{i: A_{m,i} \neq -1\}$. In the following, we describe a main part of the layered decoder 404, depicted in **Fig. 10.** This part processes in parallel $S$ consecutive rows of $[\mathbf{H}_1\ \mathbf{H}_0]$ and thus also of $\mathbf{H}_{\text{conv}}$, corresponding to a single line in the QC lifting matrix $\mathbf{A}$.

In the following, we describe the three steps for a single row $m$ of $\mathbf{A}$. The decoder module accepts as a parameter $r$ the current window position $1 \leq r \leq w$ under consideration. Note that in contrast to the binary case all tets may be represented by a vector of two LLRs, respectively (see above). This is indicated by the double lines in Fig. 10. Hence, in some embodiments the LDPC decoder 404 is an iterative decoder and is operable to update two Log-Likelihood ratios $L_1(z)$ and $L_2(z)$ per received signal sample $z$ per decoder iteration.

A first step of a decoder iteration includes computing $S\cdot\text{card}(\mathcal{N}_\mathbf{A}(m)) = S\cdot d_c$ (card = car-dinality) temporary values $\mathbf{t}_{m,i,s}$, with

$$\mathbf{t}_{m,i,s} = f_s(\hat{\mathbf{z}}_{i+rN/S}, A_{m,i}) - \mathbf{e}_{r,m,i,s} \qquad \text{for all } i \in \mathcal{N}_\mathbf{A}(m) \text{ and } s \in [1;S] \qquad (1)$$

for all non-zero entries (indexed by $i$) of the $m$'th row of $\mathbf{A}$. The function $f_s(\mathbf{z},A_{m,i})$ returns the $s$'th entry after cyclically shifting the portion of the dimension $S$ input vector $\hat{\mathbf{z}}_{i+rN/S}$ by $A_{m,i}$ positions. The value $e_{r,m,i,s}$ denotes the (stored) extrinsic memory for row $m$ and variable $\hat{z}_{i+rN/S,s}$. At the beginning of the decoding of a single frame, all $e_{r,m,i,s}$ may be initialized by zero and then be continuously updated. Note that in total $S\cdot w\cdot\Sigma_m \text{card}(\mathcal{N}_\mathbf{A}(m))$ memory locations may be required for storing the $e_{r,m,i,s}$.

In a second step, the extrinsic memory 1004 may be updated using a check node operation 1002 defined below.

Finally, in a third step, the LLR memory 1006 may be updated according to

$$\widetilde{\mathbf{z}}_{i+rN/S,s} = \mathbf{t}_{m,i,s} + \mathbf{e}_{r,m,i,s} \qquad \text{for all } i \in \mathcal{N}_\mathbf{A}(m) \text{ and } s \in [1;S] \qquad (2)$$

and

$$\hat{\mathbf{z}}_{i+rN/S} = f_s^{-1}\left(\tilde{\mathbf{z}}_{i+rN/S,1},...,\tilde{\mathbf{z}}_{i+rN/S,S}, A_{m,i}\right).$$

Then the decoder 404 may continue with decoding the next row $m$ of **A**. The decoder 404 may start with $m = 1$ and $r = 1$. After all rows of $[\mathbf{H}_1 \mathbf{H}_0]$ have been processed ($m = M'$), the decoder 404 can either do more iterations for that row (resetting $m = 1$), or can increase r, to process the next stair of the staircase-like structure of the parity-check matrix. After all stairs have been processed ($r = w$), then the decoder 404 can either continue to the next step of the cycle 900, or reset $r$ ($r = 1$, together with resetting $m$) and carry out more iterations. The exemplary decoder 404 of Fig. 10 shows the situation for $\mathrm{card}(\mathcal{N}_{\mathbf{A}}(m)) = 4$.

The check node operation 1002 in the decoder 404 may be efficiently implemented in the LLR domain, for example, as introduced in H. Wymeersch, H. Steendam, M. Moeneclaey, "Log-Domain Decoding of LDPC codes over GF(q)", in IEEE Intl. Conf. on Communications (ICC), 2004. Let us define

$$\mathbf{L}(A_1 v_1 + A_2 v_2) = \oplus(\mathbf{L}(v_1), \mathbf{L}(v_2), A_1, A_2)$$

$$= \begin{pmatrix} \ln\left[\exp(L_1(v_1) + L_{A_2(1-A_1)}(v_2)) + \exp(L_2(v_1) + L_{A_2(1-2A_1)}(v_2)) + \exp(L_{A_2}(v_2))\right] - D \\ \ln\left[\exp(L_1(v_1) + L_{A_2(2-A_1)}(v_2)) + \exp(L_2(v_1) + L_{2A_2(1-A_1)}(v_2)) + \exp(L_{A_2}(v_2))\right] - D \end{pmatrix}^T$$

with

$$D = \ln\left(1 + \exp(L_1(v_1) + L_{-A_1 A_2}(v_2)) + \exp(L_2(v_1) + L_{-2A_1 A_2}(v_2))\right),$$

where operations for computing the indexes of the vectors **L** are performed in GF(3) and where we already used the advantageous fact that in GF(3), $x^{-1} = x$ (see Table 1). We further define $L_0(x) = 0$. For instance, if $A_1 = 2$ and $A_2 = 1$, then $L_{2 \cdot A2(1-A1)} = L_{2(1-2)} = L_1$. Note that this operation makes use of the well-known and widely utilized Jacobian logarithm, which is defined as

$$\mathrm{Jac}(a,b) = \ln\left(e^a + e^b\right) = \max(a,b) + \underbrace{\ln\left(1 + e^{-|a-b|}\right)}_{\eta(a-b)} \approx \max(a,b)$$

and

$$\mathrm{Jac}(a,b,c) = \mathrm{Jac}(a, \mathrm{Jac}(b,c)) = \mathrm{Jac}(\mathrm{Jac}(a,b),c).$$

Ignoring the correction term $\eta(a-b)$ leads to the known Max-log approximation. The term $\eta(a-b)$ may also be determined using a Look-Up Table (LUT). We thus get

$$\mathbf{L}(A_1 v_1 + A_2 v_2) = \oplus(\mathbf{L}(v_1), \mathbf{L}(v_2), A_1, A_2)$$

$$= \begin{pmatrix} Jac(L_1(v_1) + L_{A_2(1-A_1)}(v_2), L_2(v_1) + L_{A_2(1-2A_1)}(v_2), L_{A_2}(v_2)) - D \\ Jac(L_1(v_1) + L_{A_2(2-A_1)}(v_2), L_2(v_1) + L_{2A_2(1-A_1)}(v_2), L_{A_2}(v_2)) - D \end{pmatrix}^T$$

with

$$D = Jac(0, L_1(v_1) + L_{-A_1 A_2}(v_2), L_2(v_1) + L_{-2A_1 A_2}(v_2)).$$

Further note that the neutral element of this operation is $(-\infty, -\infty)$ with corresponding A = 1. The check node operation 1002 can be implemented by building intermediate variables corresponding to partial checks (from left and right). Let $\mathcal{N}(m) = \{i : H_{m,i} \neq 0\}$ denote the set of all the non-zero indices of row $m$ of the parity-check matrix **H**

and let $\mathcal{N}_j(\mathrm{m})$ denote the $j$'th element of $\mathcal{N}(m)$. Then we get the partial variables by the recursion

$$\boldsymbol{\sigma}_{m,j} = \oplus(\boldsymbol{\sigma}_{m,j-1}, \mathbf{L}(v_{\mathcal{N}_j(m)}), 1, H_{m,\mathcal{N}_j(m)})$$

$$\boldsymbol{\rho}_{m,j} = \oplus(\boldsymbol{\rho}_{m,j+1}, \mathbf{L}(v_{\mathcal{N}_j(m)}), 1, H_{m,\mathcal{N}_j(m)})$$

which may be carried out for each $j$ in the range $[1, \mathrm{card}(\mathcal{N}(m))]$ and with a boundary initialized by

$$\boldsymbol{\sigma}_{m,0} = (-\infty, -\infty)$$

$$\boldsymbol{\rho}_{m,|N(m)|+1} = (-\infty, -\infty).$$

An outgoing message, which is the extrinsic information that is stored in the extrinsic memory 1004, may finally be computed as

$$\mathbf{L}(c_{m,N_j(m)}) = \oplus(\boldsymbol{\sigma}_{m,j-1}, \boldsymbol{\rho}_{m,j+1}, -H_{m,N_j(m)}, -H_{m,N_j(m)})$$

In the row decoding framework of course the entries of the set $\mathcal{N}(m)$ can be replaced by $\mathcal{N}_A(m)$, which have not explicitly be given here for clarity.

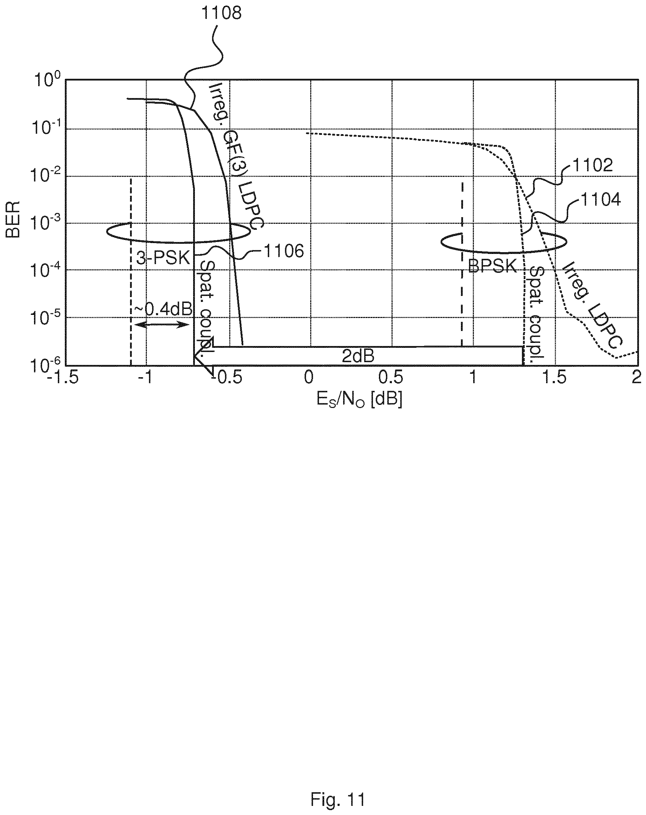

**Fig. 11** shows a simulation example.

The reference scheme is a BPSK transmission with a rate 0.79 (26% FEC overhead) coding scheme. We consider two reference schemes: first an irregular LDPC code 1102 and a spatially coupled LDPC code 1104 with a similar construction as presented above of baseline rate 0.8 shortened to 0.79. The protograph matrix of this code was $\mathbf{B}_{\mathrm{row}} = [\mathbf{B}_1 \ \mathbf{B}_0] = [2\ 2\ 2\ 2\ 3 \mid 2\ 2\ 2\ 2\ 1]$. The corresponding 3-PSK scheme with the same spectral utilization (0.79 bit/channel use) then employs a rate ½ coding scheme (100% overhead). We employ two different 3-PSK coding schemes: the scheme introduced above utilizing a spatially coupled code as presented above (numeral 1106). The second reference 1108 uses an irregular GF(3) LDPC code with the degree distribution derived in G. Li, I. J. Fair, and W. A. Krzymien, "Density Evolution for Nonbinary LDPC Codes under Gaussian Approximation," IEEE Trans. Inform. Theory, vol. 55, no. 3., Mar 2009. We employ a window-based layered decoding with $w$=12 and carry out 25 iterations per window. We can observe from Fig. 11 that we can indeed recover the 2dB performance loss introduced by BPSK transmission and can achieve a performance within 0.4 dB of the capacity limit.

To summarize, some embodiments may help to increase the coding gain for ultra-long-haul submarine optical communications in order to extend the transmission reach. For that, one idea is to abandon the BPSK transmission in favor of a ternary modulation scheme that allows higher coding gains as the gap of its modulation constrained capacity to the Shannon limit is smaller. Some embodiments propose a 3-PSK modulation format which allows a 2dB capacity gain together with a high robustness against phase noise. One possibility is to use a binary-to-ternary conversion together with a non-binary spatially coupled coding scheme over the field GF(3) adapted to the modulation format. At the receiver, a fast-converging window-based layered decoding scheme may be used to achieve a performance close to capacity

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "means for s.th." may as well be understood as a "means being adapted or suited for s.th.". A means being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1. A transmitter (210), comprising:

   a binary-to-ternary converter (202) operable to convert a binary signal (201) to a ternary signal (203) and comprising
   a concatenation of multiple division-by-3 circuits, wherein an output of a division-by-3 circuit corresponds to a modulo-3 remainder of the corresponding division-by-3;
   an Low-Density Parity-Check, LDPC, encoder (402) operable to encode the ternary signal (203) according to a Low-Density Parity-Check encoding scheme; and
   a modulator (204) operable to select, corresponding to the encoded ternary signal (203), one or more complex valued modulation symbols (205) from a ternary constellation diagram.

2. The transmitter (210) of claim 1, further comprising a scrambler coupled to the binary to ternary converter and operable to scramble the ternary signal.

3. The transmitter (210) of claim 1, wherein the modulator (204) is operable to select the complex valued modulation symbols (205) according to a ternary Phase-Shift Keying (3-PSK) modulation scheme.

4. The transmitter (210) of claim 1, wherein the modulator (204) is operable to select a complex valued modulation symbol (205) from the transmit symbol set

$$y \in \left\{ \exp\left(i\left(\frac{2\pi}{3} + O\right)\right), \exp\left(i\left(\frac{4\pi}{3} + O\right)\right), \exp(i(2\pi + O)) \right\},$$

with O being an arbitrary fixed phase offset factor and i being the imaginary unit ($i^2$ = -1).

5. The transmitter (210) of claim 1, wherein the LDPC encoder (402) is an LDPC block or convolutional encoder.

6. The transmitter (210) of claim 1, wherein the LDPC encoder (402) comprises an input coupled to an output of the binary-to-ternary converter (202), an output coupled to an input of the modulator (204), and wherein the LDPC encoder (402) is operable to encode the ternary signal (203) at its input to obtain an encoded ternary signal (203') at its output.

7. The transmitter (210) of claim 1, wherein entries of a parity-check matrix defining an LDPC block or convolutional code of the LDPC encoder (402) take values in the Galois field GF(3).

8. The transmitter (210) of claim 1, wherein the transmitter is operable to transmit the modulation symbols (205) over an optical transmission channel (206).

9. A receiver (220), comprising:

a demodulator (208) operable to estimate a ternary transmit signal (209) based on a comparison of a received signal (207) with hypothetical modulation symbols (205) from a ternary constellation diagram,

the receiver being **characterized by**:

a Low-Density Parity-Check, LDPC, decoder (404) operable to decode the estimated ternary transmit signal (209) to obtain a decoded ternary signal (209'); and
a ternary-to-binary converter (210) operable to convert the decoded ternary transmit signal (209) to a binary signal (211) and comprising
a concatenation of multiple division-by-2 circuits, wherein an output of a division-by-2 circuit corresponds to a modulo-2 remainder of the corresponding division-by-2.

10. The receiver (220) of claim 9, further comprising a descrambler (222) coupled between the LDPC decoder (404) and the ternary-to-binary converter (210) and operable to descramble the ternary signal.

11. The receiver (220) of claim 9, wherein the demodulator (208) is operable to determine two likelihood values per received signal sample, wherein a first likelihood value is indicative of a ratio of probabilities related to a first hypothetical transmit symbol and a second hypothetical transmit symbol of the ternary constellation diagram, and wherein a second likelihood value is indicative of a ratio of probabilities related to a third hypothetical transmit symbol and the second hypothetical transmit symbol of the ternary constellation diagram.

12. The receiver (220) of claim 9, wherein the LDPC decoder (404) is an LDPC block or convolutional decoder.

13. The receiver (220) of claim 9, wherein the LDPC decoder (404) comprises
an input coupled to an output of the demodulator (208),
an output coupled to an input of the ternary-to-binary converter (210), and wherein the LDPC decoder (404) is operable to decode estimates (209) of encoded ternary symbols from the demodulator to obtain a decoded ternary signal (209') at its output.

14. The receiver (220) of claim 9, wherein the LDPC decoder (404) is an iterative decoder and is operable to update two log-likelihood ratios per estimated ternary transmit symbol per decoder iteration.

**Patentansprüche**

1. Sender (210), umfassend:

einen Binär-zu-Ternär-Wandler (202), der betreibbar ist zum Umwandeln eines Binärsignals (201) in ein Ternärsignal (203) und umfassend eine Verkettung mehrerer Division-durch-Drei-Schaltkreise, wobei ein Ausgang eines Division-durch-Drei-Schaltkreises einem Modulo-3-Rest der entsprechenden Division durch Drei entspricht;

einen LDPC-Codierer (Low Density Parity Check) (402), der betreibbar ist zum Codieren des Ternärsignals (203) gemäß einem LDPC-Schema (Low Density Parity Check); und

einen Modulator (204), der betreibbar ist zum Auswählen, entsprechend dem codierten Ternärsignal (203), eines oder mehrerer komplexwertiger Modulationssymbole (205) aus einem ternären Konstellationsdiagramm.

2. Sender (210) nach Anspruch 1, weiterhin umfassend einen Scrambler, der mit dem Binär-zu-Ternär-Wandler gekoppelt ist und betreibbar ist zum Chiffrieren des Ternärsignals.

3. Sender (210) nach Anspruch 1, wobei der Modulator (204) betreibbar ist zum Auswählen der komplexwertigen Modulationssymbole (205) gemäß einem ternären 3-PSK-Modulationsschema (Phase Shift Keying).

4. Sender (210) nach Anspruch 1, wobei der Modulator (204) betreibbar ist zum Auswählen eines komplexwertigen Modulationssymbols (205) aus dem Übertragungssymbolsatz

$$y \in \left\{ \exp\left( i\left( \frac{2\pi}{3} + O \right) \right), \exp\left( i\left( \frac{4\pi}{3} + O \right) \right), \exp\left( i(2\pi + O) \right) \right\},$$

wobei O ein willkürlich festgesetzter Phasen-Offset-Faktor ist und i die imaginäre Einheit ($i^2 = -1$).

5. Sender (210) nach Anspruch 1, wobei der LDPC-Codierer (402) ein LDCP-Block- oder Faltungscodierer ist.

6. Sender (210) nach Anspruch 1, wobei der LDPC-Encoder (402) umfasst einen Eingang, der gekoppelt ist mit einem Ausgang des Binär-zu-Ternär-Wandlers (202),
einen Ausgang, der mit einem Eingang des Modulators (204) gekoppelt ist, und wobei der LDPC-Encoder (402) betreibbar ist zum Codieren des Ternärsignals (203) an seinem Eingang, um ein codiertes Ternärsignal (203') an seinem Ausgang zu erhalten.

7. Sender (210) nach Anspruch 1, wobei die Einträge einer PC-Matrix (Parity Check), die einen LDPC-Block oder Faltungscode des LDPC-Encoders (402) definiert, Werte im Galois-Feld GF(3) annimmt.

8. Sender (210) nach Anspruch 1, wobei der Sender betreibbar ist zum Übertragen der Modulationssymbole (205) über einen optischen Übertragungskanal (206).

9. Empfänger (220), umfassend:

einen Demodulator (208), der betreibbar ist zum Abschätzen eines ternären Übertragungssignals (209) auf Grundlage eines Vergleichs eines empfangenen Signals (207) mit hypothetischen Modulationssymbolen (205) aus einem ternären Konstellationsdiagramm,

wobei der Empfänger **gekennzeichnet ist durch**:

e inen LDPC-Decoder (Low Density Parity Check) (404), der betreibbar ist zum Decodieren des abgeschätzten ternären Übertragungssignals (209) zum Erhalten eines decodierten Ternärsignals (209'); und
e inen Ternär-zu-Binär-Wandler (210), der betreibbar ist zum Umwandeln des decodierten Ternärsignals (209) in einer Binärsignal (211) und umfassend eine Verkettung mehrerer Division-durch-Zwei-Schaltkreise, wobei ein Ausgang eines Division-durch-Zwei-Schaltkreises einem Modulo-2-Rest der entsprechenden Division **durch** Zwei entspricht.

10. Empfänger (220) nach Anspruch 9, weiterhin umfassend einen Descrambler (222), der gekoppelt ist zwischen dem LDPC-Decoder (404) und dem Ternär-zu-Binär-Wandler (210) und betreibbar zum Dechiffrieren des Ternärsignals.

11. Empfänger (220) nach Anspruch 9, wobei der Demodulator (208) betreibbar ist zum Bestimmen zweier Wahrscheinlichkeitswerte pro empfangenem Signalmuster, wobei ein erster Wahrscheinlichkeitswert indikativ ist für ein Verhältnis von Wahrscheinlichkeiten, die verbunden sind mit einem ersten hypothetischen Übertragungssignal und einem zweiten hypothetischen Übertragungssymbol des ternären Konstellationsdiagramms, und wobei ein zweiter Wahrscheinlichkeitswert indikativ ist für ein Verhältnis von Wahrscheinlichkeiten, die verbunden sind mit einem dritten hypothetischen Übertragungssymbol des ternären Konstellationsdiagramms.

**12.** Empfänger (220) nach Anspruch 9, wobei der LDPC-Decoder (404) ein LDCP-Block- oder Faltungsdecoder ist.

**13.** Empfänger (220) nach Anspruch 9, wobei der LDPC-Decoder (404) umfasst einen Eingang, der mit einem Ausgang des Demodulators (208) gekoppelt ist, einen Ausgang, der mit einem Eingang des Ternär-zu-Binär-Wandler (210) gekoppelt ist, und
wobei der LDPC-Decoder (404) betreibbar ist zum Decodieren von Abschätzungen (209) codierter ternärer Symbole aus dem Demodulator, um ein decodiertes Ternärsignal (209') als Ausgang zu erhalten.

**14.** Empfänger (220) nach Anspruch 9, wobei der LDPC-Decoder (404) ein iterativer Decoder ist und betreibbar zum Aktualisieren von zwei Log-Wahrscheinlichkeitsverhältnissen pro abgeschätztem, ternärem Übertragungssymbol pro Decoder-Iteration.

**Revendications**

**1.** Émetteur (210), comprenant :

un convertisseur binaire-ternaire (202) permettant de convertir un signal binaire (201) en un signal ternaire (203) et comprenant une concaténation de multiples circuits de division par 3, une sortie d'un circuit de division par 3 correspondant à un reste modulo 3 de la division par 3 correspondante ;
un codeur à contrôle de parité de faible densité, LDPC, (402) permettant de coder le signal ternaire (203) selon un schéma de codage à contrôle de parité de faible densité ; et
un modulateur (204) permettant de sélectionner, en correspondance avec le signal ternaire codé (203), un ou plusieurs symboles de modulation à valeur complexe (205) d'un diagramme de constellation ternaire.

**2.** Émetteur (210) selon la revendication 1, comprenant en outre un embrouilleur connecté au convertisseur binaire-ternaire et permettant d'embrouiller le signal ternaire.

**3.** Émetteur (210) selon la revendication 1, dans lequel le modulateur (204) permet de sélectionner les symboles de modulation à valeur complexe (205) selon un schéma de modulation à modulation par déplacement de phase ternaire (3-PSK).

**4.** Émetteur (210) selon la revendication 1, dans lequel le modulateur (204) permet de sélectionner un symbole de modulation à valeur complexe (205) dans l'ensemble des symboles de transmission,

$$y \in \left\{ \exp\left( i\left( \frac{2\pi}{3} + O \right) \right), \exp\left( i\left( \frac{4\pi}{3} + O \right) \right), \exp(i(2\pi + O)) \right\},$$

O étant un facteur de déphasage fixe arbitraire et i étant l'unité imaginaire ($i^2 = -1$).

**5.** Émetteur (210) selon la revendication 1, dans lequel le codeur LDPC (402) est un bloc LDPC ou un codeur convolutionnel.

**6.** Émetteur (210) selon la revendication 1, dans lequel le codeur LDPC (402) comprend
une entrée connectée à une sortie du convertisseur binaire-ternaire (202),
une sortie connectée à une entrée du modulateur (204), et
dans lequel le codeur LDPC (402) permet de coder le signal ternaire (203) à son entrée pour obtenir un signal ternaire codé (203') à sa sortie.

**7.** Émetteur (210) selon la revendication 1, dans lequel les entrées d'une matrice de contrôle de parité définissant un bloc LDPC ou un code convolutionnel du codeur LDPC (402) prennent leurs valeurs dans le champ de Galois GF(3).

**8.** Émetteur (210) selon la revendication 1, dans lequel l'émetteur permet de transmettre les symboles de modulation (205) sur un canal de transmission optique (206).

**9.** Récepteur (220), comprenant :

un démodulateur (208) permettant d'estimer un signal de transmission ternaire (209) sur la base d'une comparaison d'un signal reçu (207) avec des symboles de modulation hypothétique (205) provenant d'un diagramme de constellation ternaire,

le récepteur étant **caractérisé par** :

u n décodeur à contrôle de parité de faible densité, LDPC, (404) permettant de décoder le signal de transmission ternaire estimé (209) pour obtenir un signal ternaire décodé (209') ; et
u n convertisseur ternaire-binaire (210) permettant de convertir le signal de transmission ternaire décodé (209) en un signal binaire (211) et comprenant une concaténation de multiples circuits de division par 2, une sortie d'un circuit de division par 2 correspondant à un reste modulo 2 de la division par 2 correspondante.

10. Récepteur (220) selon la revendication 9, comprenant en outre un désembrouilleur (222) connecté entre le décodeur LDPC (404) et le convertisseur ternaire-binaire (210) et permettant de désembrouiller le signal ternaire.

11. Récepteur (220) selon la revendication 9, dans lequel le démodulateur (208) permet de déterminer deux valeurs de probabilité par échantillon de signal reçu, dans lequel une première valeur de probabilité indique un rapport de probabilité relatif à un premier symbole de transmission hypothétique et un deuxième symbole de transmission hypothétique du diagramme de constellation ternaire, et dans lequel une deuxième valeur de probabilité indique un rapport de probabilité relatif à un troisième symbole de transmission hypothétique et au deuxième symbole de transmission hypothétique du diagramme de constellation ternaire.

12. Récepteur (220) selon la revendication 9, dans lequel le décodeur LDPC (404) est un bloc LDPC ou un décodeur convolutionnel.

13. Récepteur (220) selon la revendication 9, dans lequel le décodeur LDPC (404) comprend
une entrée connectée à une sortie du démodulateur (208),
une sortie connectée à une entrée du convertisseur ternaire-binaire (210), et dans lequel le décodeur LDPC (404) permet de décoder des estimations (209) de symboles ternaires codés en provenance du démodulateur pour obtenir un signal ternaire décodé (209') à sa sortie.

14. Récepteur (220) selon la revendication 9, dans lequel le décodeur LDPC (404) est un décodeur itératif et permet de mettre à jour deux rapports de probabilité logarithmique par symbole de transmission ternaire estimé par itération du décodeur.

202

201

19 bit U

302 — Division by 3 circuit → $X_{12}$

18 bit

302 — Division by 3 circuit → $X_{11}$

16 bit

302 — Division by 3 circuit → $X_{10}$

15 bit

• • •

a

Division by 3 circuit → r

q

a=3q+r

302

2 bit

302 — Division by 3 circuit → $X_1$

400

210

402

202

201

204

$U_t$ → Binary to Ternary → $X_t$ → Spatially Coupled GF(3) Encoder → $Y_t$ → 3-PSK Modulation

203

203´

206

$Y_{t-1}$ ← T ← ternary digits

Optical Channel

$U_{t-w}$ ← Ternary to Binary ← Windowed Non-Binary GF(3) SC-Decoder ← 3-PSK Demod. ←

210

209´

404

209

208

220

Fig. 5

nz=315

Fig. 6

700

$$B = \begin{pmatrix} 2 & 1 & & & & & \\ 2 & 3 & 2 & 1 & & & \\ & & 2 & 3 & 2 & 1 & \\ & & & & 2 & 3 & 2 & 1 \\ & & & & & & 2 & 3 & 2 & 1 \\ & & & & & & & & \ddots & \ddots & \ddots & \ddots \end{pmatrix}$$

Fig. 7

800

Fig. 8

aposteriori memory

new chunk received from channel/DSP

900

902

$H =$

Window length w

1

904

aposteriori memory

$H =$

2

Iteratively process

908

aposteriori memory

shift memory

descision

4

$H =$

aposteriori memory

3

$H =$

906

Fig. 9

Fig. 10

Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Ternary phase shift keying and its Performance. **NAKAMURA et al.** Wireless Personal Multimedia Communications. IEEE, 27 October 2002, vol. 3, 1284-1288
- On Non-Binary Constellations for Channel-Coded Physical-Layer Network Coding. **ZAHRA FARAJI-DANA et al.** IEEE Transactions on Wireless Communications. IEEE, 01 January 2013, vol. 12, 312-319
- Linear-Programming Decoding of Non-binary Linear Codes. **FLANAGAN et al.** IEEE Transactions on Information Theory. IEEE Press, 01 September 2009, vol. 55, 4134-4154
- Computational complexity and quantization effects of decoding algorithms for non-binary LDPC codes. **WYMEERSCH et al.** Acoustics, Speech, and Signal Processing. IEEE, 17 May 2004, vol. 4, 669-672

- **A. IYENGAR et al.** *Windowed decoding of protograph-based LDPC convolutional codes over erasure channels,* 2011
- **D. E. HOCEVAR.** A Reduced Complexity Decoder Architecture via Layered Decoding of LDPC Codes. *Proc. IEEE Workshop on Signal Processing Systems (SIPS),* 2004
- **H. WYMEERSCH ; H. STEENDAM ; M. MOENECLAEY.** Log-Domain Decoding of LDPC codes over GF(q). *IEEE Intl. Conf. on Communications (ICC),* 2004
- **G. LI, I. J. FAIR ; W. A. KRZYMIEN.** Density Evolution for Nonbinary LDPC Codes under Gaussian Approximation. *IEEE Trans. Inform. Theory,* March 2009, vol. 55 (3.